# EUROPEAN PATENT APPLICATION

(11) **EP 1 096 569 A1**
(43) Date of publication of application: **02.05.2001**
(21) Application number: 99121606.0
(22) Date of filing: 29.10.1999
(51) Int. Cl.: H01L 27/10, H01L 29/86, H01L 29/66, H01L 29/16, H01L 29/24, H01L 51/20, H01L 21/8256, H01L 21/263

(54) **Quantum wire array, uses thereof, and methods of making the same**

(71) Applicant: Ohnesorge, Frank, Dr., 82205 Gilching (DE)
(72) Inventor: Ohnesorge, Frank, 64291 Darmstadt (DE); Weidinger, Alois, 14129 Berlin (DE); Neumann, Reinhard, 64291 Darmstadt (DE); Toulemond, Marcel, c/o CERIL, Lab. Com., CEA-CNRS, 14040 Caen Cedex 5 (FR); Trautmann, Christina, 64291 Darmstadt (DE); Witke, Thomas, c/o Fraunhofer Gesellschaft, 01277 Dresden (DE)

(57) **Abstract**

The present invention relates to an array (4) of one-dimensional quantum wires (6) useable for electronic circuitry, logic circuitry and flat display circuitry, wherein the array comprises a semi-insulating or insulating solid film (3,5) and a plurality of one dimensional quantum wires embedded with their longitudinal extension within said film and accessible at their end portions (7,8) on both surfaces (9,10) of said film and a method for producing such an array of one-dimensional quantum wires by forming an insulating or semi-insulating film and creating latent ion tracks to form quantum wires within said film by directing a beam of fast heavy ions toward the surface of said film. Where the solid film is made of amorphous carbon having insulating diamond-like bonds, the heavy ions generate conductive graphite-like bonds in the solid film. The quantum wires may form logical cells of a multilevel logic device and may then comprise a quantum interference device (13,14,15,23,24,25) to read out the stored information.

## Description

The invention relates to an array of one-dimensional quantum wires and a method for producing same.

Such an array of one-dimensional quantum wires is useable for electronic circuitry, logic circuitry and flat display circuitry. Further applications can be interconnections to inorganic/organic nanometer-scale structures like metal colloidal particles, nanocrystals, organic molecules etc..

Conventional one-dimensional quantum wires are formed on thin surface layers. These wires have the disadvantage of degrading in an ambient environment by partially oxidising the thin surface layer. Further, there is a thermal problem at high switching speeds, since the cooling probabilities of thin surface layers are quite limited. Further, the accessibility to the quantum wire end portions of a thin surface layer structure is quite complicated.

Therefore, it is the object of the present invention to provide an array of one-dimensional quantum wires for extreme further miniaturisation with high switching speeds in nanometer-scale devices with ballistic charge carrier transport without significant energy dissipation and no thermal problems.

Further, it is the object of the present invention to provide a method for conveniently fabricating of a large number of one-dimensional quantum wires within a three-dimensional body.

This object is achieved by the subject matter of claim 1, claim 18 and claim 20 of the present invention.

Such an array of one-dimensional quantum wires comprises a semi-insulating or insulating solid film and a plurality of one-dimensional quantum wires completely firmly and tightly embedded with their longitudinal extension within said film and accessible at their end portions on both surfaces of said film.

Such an array has the advantage that the length of the quantum wires are defined by the thickness of the semi-insulating or insulating solid film and by the angle between the semi-insulating or insulating solid film and the surfaces of said film. It is preferred to arrange the quantum wires perpendicular to said surfaces, but it is also possible to enlarge their longitudinal extension by forming oblique quantum wires in said film. The tilt angle can be as small as 30° between the film surface and the longitudinal axis of the quantum wire. Another advantage is that the wires cannot degrade in ambient conditions, since they are completely and firmly and tightly embedded within said film so that they are never exposed with their longitudinal extension to the environment. Further, the end portions of said quantum wires are easily accessible since it is possible to contact same on both surfaces of said film and to apply a voltage on both ends. In the first preferred embodiment there is formed a common electrode on one side of the array and individual contact tips on the other side of the array mainly to measure the staircase-like current versus voltage characteristic which is exhibit for this inventive quantum wire at room temperature.

On the contrary, most conventional quantum wires arranged on thin film surface layers operate only when cooled down to temperatures below 0° C. A further advantage is that there are no thermal problems at high switching speeds since during the quantum mechanical transport of electrons in a one-dimensional structure, there occurs no significant energy dissipation and the remaining dissipation can be easily absorbed by the surrounding matrix of the film material.

In a preferred embodiment of the present invention, the end portion of said plurality of quantum wires are arbitrarily arranged in respect to the surface of said film in an average centre distance between 10 and 5.000 nm. This distance is governed by the method for producing such an array of one-dimensional quantum wires. The main step within such a method described below is directing a beam of fast heavy ions toward the surface of said film to create latent ion tracks. Therefore the centre distance between the quantum wires within said array is governed by the spreading of said beam creating by each heavy ion one quantum wire within said film. Further, this distance depends on the beam current of said fast heavy ions which preferably is between 1 x 10⁵ and 1 x 10⁷ ions per cm² and per second. The higher the beam current and the smaller the spreading of the beam, the smaller will be the average centre distance. Therefore, it is most preferable to generate an average centre distance between 10 to 100 nm for the array of one-dimensional quantum wires. But also single quantum wires on predetermined locations can be accomplished by ion beam intensities of 1 ion per second or more.

The longitudinal extension as mentioned before depends mainly on the thickness of the film and the energy of a single ion passing said film in a predetermined angle. The most preferable longitudinal extension of said plurality of quantum wires within said array is more than 100 nm and less than 2.000 nm. For further extreme miniaturisation preferred longitudinal extension of said plurality of quantum wires is less than 100 nm and more than 20 nm.

To gain a quantum switching effect with said one-dimensional quantum wires, the diameter is preferably partially less than 2 nm within said film and more than 2 nm up to 10 nm near to and on the surface of said film. Such small size has the advantage that the average centre distance can be very small as mentioned above, but the lower limit of 10 nm has more or less practical reasons since right now there are still difficulties to provide spaced apart conductive pathes in a range below the size of said quantum wire diameter and a minimum average centre distance of 10 nm.

In a preferred embodiment of the present invention the film comprises amorphous carbon with diamond-like bonds. Such films can be deposited on high-doped silicon wafers by known techniques. The diamond-like bonds in amorphous materials like carbon are known as highly insulating bonds with a large band-gap. But especially, this amorphous carbon with diamond-like bonds can strongly alternate to graphite-like bonds, if fast heavy ions are passing through the material. Therefore, when passing through such a foil or film of a suitable electrically insulating material, a very large assembly of electrically conducting wires can be formed, which diameter is so small that one-dimensional quantum wires are created.

Other preferred materials for said film are one of the group of silicon carbid, polymers containing carbon and amorphous semiconductors.

In a preferred embodiment of said array of one-dimensional quantum wires, each of said quantum wires represents one logical cell of a multi level logic device, wherein the quantized current levels represent a stored information and a read out is done by a quantum interference device, measuring the current flowing along the quantum wire by detecting the magnetic field produced by said current. Such a structure has the advantage to be able to store information very compact and in a very dense scale so that the storage density is increased by several orders of magnitude compared to conventional storage devices.

Therefore, a preferred application of the array of one-dimensional quantum wires is an interface layer between nanometer scale electronic devices interconnecting logical units to form a logical network, wherein quantum interference device detectors are realised on the basis of quantum wires. Such interface layer have the possibility to conduce through said interface layer a huge number of information at high speed.

Another preferred application of the present invention is an interconnect structure for nanometer electronic structures of multi level logic computers based on the quantum mechanical effect of the one-dimensional quantum wire. According to the quantum mechanical transport and the staircase-like "current versus voltage" characteristic curve of said one-dimensional quantum layer, these computers can be designed with much more than two states of information per logical unit, since as many possible states as current levels can be resolved in the staircase-like current versus voltage curve. Therefore, the logical unit comprising and based on the array of one-dimensional quantum wires can count from 0 to 7 or more and not only from 0 to 1 as in the binary transistor logic. In a further preferred application of the array of one-dimensional quantum wires a quantum interference device at room temperature can be produced. For this purpose, one end portion of each quantum wire is surrounded by a conducting ring for detecting the magnetic field produced by the current through said quantum wire. The leads of such quantum interference ring surrounding each quantum wire could be other quantum wires applied at the same way by irradiation.

One method for producing an array of one-dimensional quantum wires comprises the steps:
depositing an insulating or semi-insulating film on a conductive substrate,
creating latent ion tracks to form quantum wires within said film by directing a beam of fast heavy ions toward the surface of said film,
forming submicrometer contact lines and terminals on said film.

Alternatively it is possible to create the quantum wires in a last step after forming submicrometer contact lines and terminals on the top surface of said film.

With this method an array is produced which is carried by the conductive substrate and this conductive substrate forms also a common electrode for all end portions of the one-dimensional quantum wires on one surface of the insulating or semi-insulating film. Instead of a tip probe like it is used to confirm that these wires allow a quantum mechanical transport of electrodes, one can also form submicrometer conductive pathes and contact terminals on the other surface of said film to contact the other end portions of said plurality of one-dimensional quantum wires.

Preferably, the conductive substrate is formed of a highly doped mono-crystalline silicon wafer. This has the advantage of a very good support of the film and it has the advantage that the film can easily be deposited on such mono-crystalline silicon wafers.

If it is necessary to have individual contacts on both surfaces of the array of one-dimensional quantum wires, there is performed an additional step in said micrometer conductive lines and contact terminals are formed on an insulating or semi-insulating substrate. These conductive lines can be straight parallel lines deposited on said insulation or semi-insulating substrate and after the deposition of said insulating or semi-insulating film to said substrate having said conductive lines, it is possible to direct now a beam of fast heavy ions toward the surface of said film which creates a large number of one-dimensional quantum wires contacting these conductive lines on the insulating substrate. After or before forming these one-dimensional quantum wires, submicrometer contact lines and terminals are formed on the top surface of said film, but these contact lines can now be provided parallel and in a direction perpendicular to the submicrometer conductive lines on the insulating substrate. Due to the arbitrary distribution and high density of the quantum wires within said array, there is a high probability said at each cross point of the two arrangements of submicrometer conductive lines a one-dimensional quantum wire is located so that with this array in connection with the wire pattern on both sides of the film a matrix of quantum wires is created.

Preferably, the method of producing an array of one-dimensional quantum wires is performed on one of the following materials: amorphous carbon with diamond-like bonds, silicon carbide, polymers containing carbon or amorphous semiconductors. Preferably the beam current of said fast heavy ions forming said one-dimensional quantum wires is performed in an ion accelerator emitting between 1 x 10⁵ and 1 x 10⁷ ions per cm² per second and for single quantum wires at predetermined location the intensity can be lowered down to 1 ion per second or as low as desired.

To create different lengths of one-dimensional quantum wires within a film of predetermined thickness said ion beam preferably impinges said film oblique to the film surface. It is also preferred to create subgroups of quantum wires of different length and/or different oblique angles in different areas of an array of one-dimensional quantum wires.

In an other preferred embodiment the method for producing an array of one-dimensional quantum wires applies the step of directing the ion beam under different angles in respect to the surface plane of said film (5) in identical areas of said array to produce counter oblique quantum wires (6) within the film (5) in a predetermined area.

Further advantages, features and application of the present invention are now illustrated in detail with respect to embodiments with reference to the accompanying drawings.

Figure 1 shows a perspective partially cut view of a first embodiment of the present invention.

Figure 2 shows a perspective partial view of a second embodiment of the present invention.

Figure 3a shows a schematic view of the operation of a quantum wire cell.

Figure 3b shows a schematic view of the operation of a quantum wire cell of a third embodiment of the present invention.

Figure 4 shows a schematic view of a measuring arrangement to measure the quantum wire characteristic.

Figure 5A to 5D show the characteristic curves of different quantum wires.

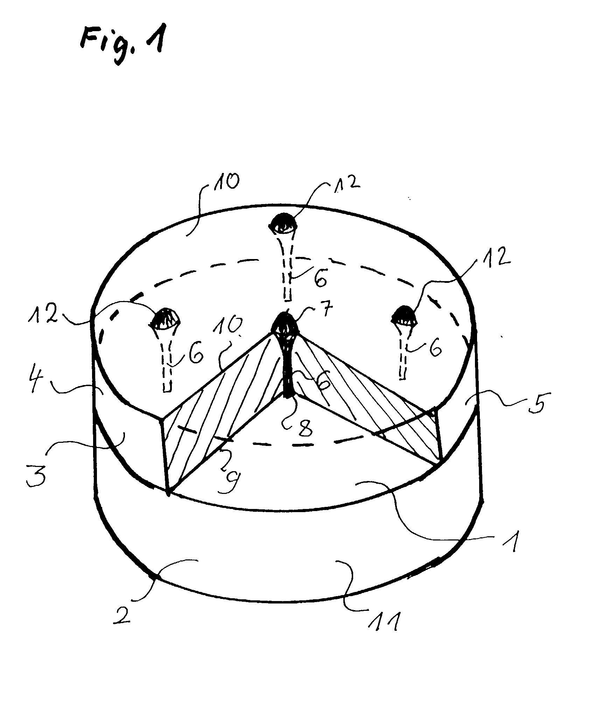

Figure 1 shows a perspective partially cut view of a first embodiment of the present invention. On a polished surface 1 of a highly doped and thus conductive silicon wafer 2 is deposited a diamond-like carbon film 3 which can be slightly doped with boron-impurities in a concentration from about 1x10¹⁵ cm⁻³ to 1x10¹⁷ cm⁻³. The silicon wafer can be highly doped by Boron atoms up to 5x10²⁰ cm⁻³ to create a p-type conducting silicon wafer or by Phosphors in a concentration of about 5x10²⁰ cm⁻³ to create an n-type conducting surface. This highly doped silicon wafer 2 with its polished surface 1 is only a substrate to carry the array 4 of one-dimensional quantum wires, which comprises a semi-insulating or insulating solid film 5 having a plurality of one-dimensional quantum wires 6 completely firmly and tightly embedded within said film 5 with their longitudinal extension and accessible at the end portions 7 and 8 on both surfaces 9 and 10 of said semi-insulating or insulating solid film 5.

Such an array shown in figure 1 is produced by depositing said insulating or semi-insulating film 5 on said conductive substrate 11 by creating latent ion tracks to form quantum wires 6 with said film 5 by directing a beam (not shown) of fast heavy ions (non shown) toward the surface of said film 5. The path of each single ion in the solid film 5 represents one quantum wire formation. The end portions 7 of said quantum wires 6 are easily contactable by a tip probe at their termination protruding out of the surface 10 of the film 5 like bumps. This is due to the impingement of said fast heavy ion on that position which alters the structure of the semi-insulating or insulating film for example in this case from a diamond bond governed amorphous carbon film to a graphite bond governed quantum wire 6. Such an alteration is accompanied by a volume extension which can build such bumps 12 at the impingement points of said fast heavy ions. The diameter of these bumps were measured by the very well known atomic force microscopy and are between 10 and 30 nanometers wide and build a protrusion height of about 1 to 2 nm above the surface 10 of film 5. The thickness of the film 5 can be normally more than 100 nm and less than 2.000 nm, but for very small miniaturisation it is preferred to have a thickness of such a film of less than 100 nm and more than 20 nm. In this special embodiment of figure 1, the longitudinal extension of the quantum wire 6 correspond with the thickness of the film 5 and the diameter within said film 5 is expected to be effectively less than 2 nm and is characterised by the latent ion track which is left after passing a fast heavy ion through said semi-insulating or insulating film 5. Since using an atomic force microscop the surface bumps 12 of said ion tracks are easily to be identified on the surface 10 of the film 5, it is possible to contact same electrically.

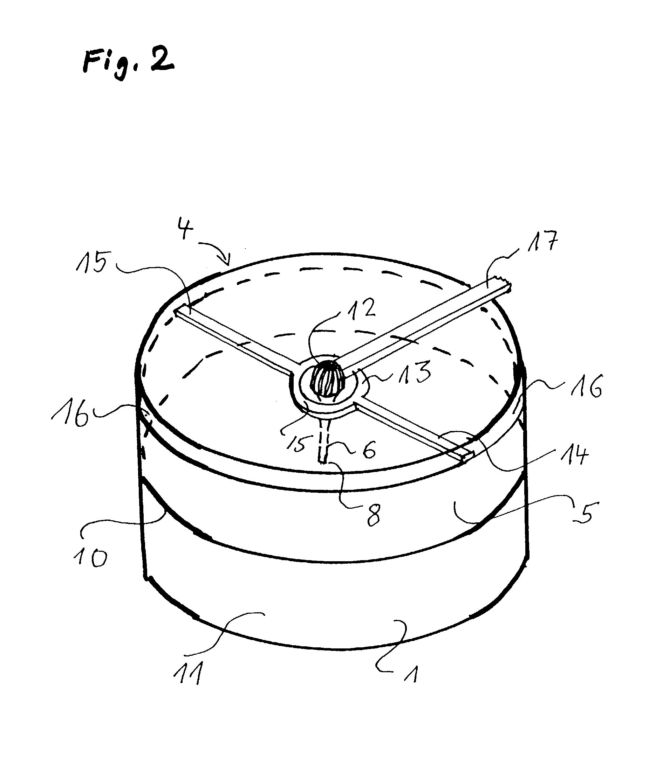

Figure 1 shows a structure with an array of a plurality of one-dimensional quantum wires which are proven by applying atom force microscopy and scanning tunnelling microscopy that the conducting latent ion tracks are quantum wires 6 indeed. The embodiment shown in figure 2 is an example for a quantum mechanical logical unit based on such one-dimensional quantum wires.

Figure 2 shows a perspective partial view of a second embodiment of the present invention when used as a logical cell. In this figure 2 the same components are identified by same reference numerals so that a detailed description is omitted.

As an example, only one of the quantum wires 6 is shown in this example. The semi-insulating or insulating solid film 5 of amorphous carbon with diamond-like bonds or silicon carbide or polymers containing carbon carries on its upper surface 10 a construction of a conductive ring surrounding the bump 12 of the quantum wire 6. The conductive ring 13 is connected to conductive paths 14 and 15. This ring structure with conductive paths is covered by an insulating layer 16 so that the whole ring structure 15 is buried between said insulating layer 16 and said film 5. The ring structure 15 surrounding the ion track wire has a thickness of about 0.5 nm to 1 nm. On top of the insulating film 16 is positioned a conducting pass 17 to contact the bump 12. With this quantum mechanical logical unit a quantum interference device is created for measuring the current flowing through the wire by detecting the magnetic stray field with the ring structure. This ring structure could be made from single crystalline metals like copper or also by another irradiation induced conductivity on the surface of the semi-insulating or insulating film.

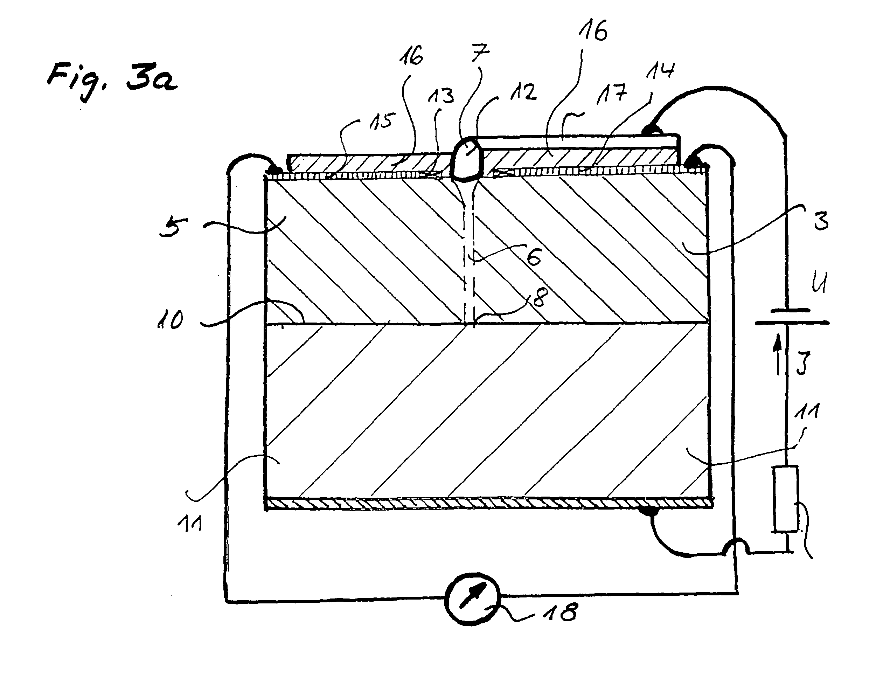

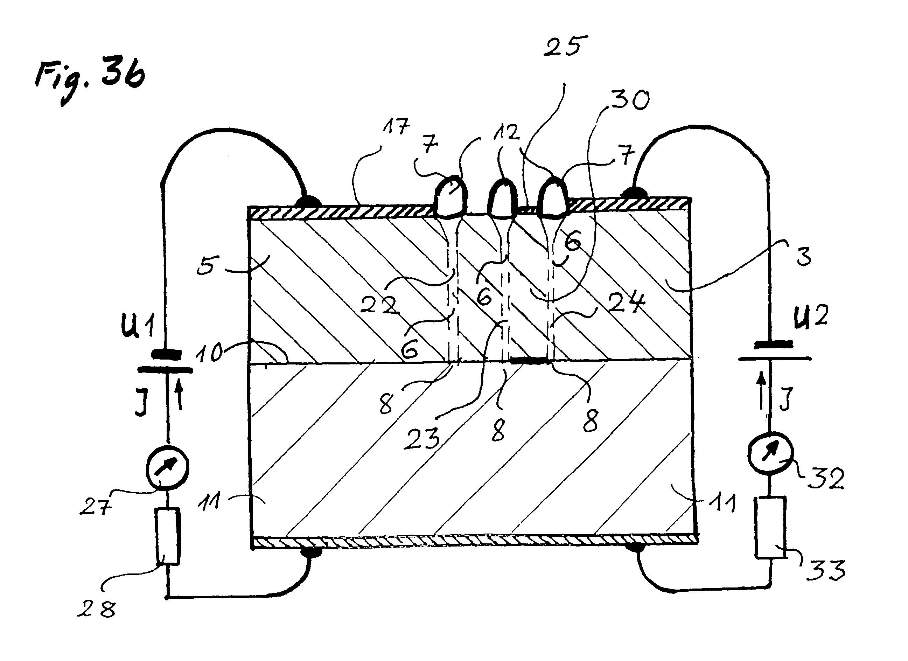

Figure 3a shows a schematic of the operation of a quantum wire cell of figure 2. Actually it shown a cross-sectional view of the example of figure 2. A voltage U is applied through a protective resistor 21 to the conductive substrate of highly doped p- or n-typed silicon which forms a common contact to all end portions 8 of the quantum wires 6 at the surface 9 of the insulating film 5 and to the upper end portion 7 through the conductive path 17 on top of the insulating layer 16. The buried quantum interference device sensing the vector potential of the magnetic stray field of the current passing through said quantum wires 6 with quantum mechanical characteristic is connected to a ampere meter 18 to indicate the quantum mechanical current passing through the quantum wire 6. In a real logical network this ampere meter would be the next quantum interference device and so on.

Figure 3b shows a schematic view of the operation of a quantum wire cell of a third embodiment of the present invention.. Actually it shown a cross-sectional view of three quantum wires. A primary quantum wire 22 is the active logical cell and two further quantum wires 23 and 24 are short circuit at the bottom portion 8 by the conductive substrate 11 and at the top portion 7 by a short quantum wire bridge 25, so that again a ring structure as a very affective detector 30 for the stray magnetic field caused by the quantum current through the primary quantum wire 22 is formed acting as read out device or as a quantum interference device like in the case of Figure 2. A voltage U1 is applied to the conductive substrate of highly doped p- or n-typed silicon which forms a common contact to the end portions 8 of the quantum wires 22, 23 and 24 at the surface 9 of the insulating film 5 and to the upper end portion 7 of the primary quantum wire is connected through the conductive path 17 on top of the insulating layer 16 with the voltage supply 26, an ampere meter 27 and a protective resistor 28. A similar external circuitry is connected to the ring-like detector 30 with second voltage U2 supply 31 a second ampere meter 32 and a resistor 33. The detector 30 is sensing as a quantum interference device the vector potential of the magnetic stray field of the current passing through said primary quantum wire 22 with quantum mechanical characteristic. In a real logical network these ampere meters 27 and 32 will be next quantum interference devices and so on.

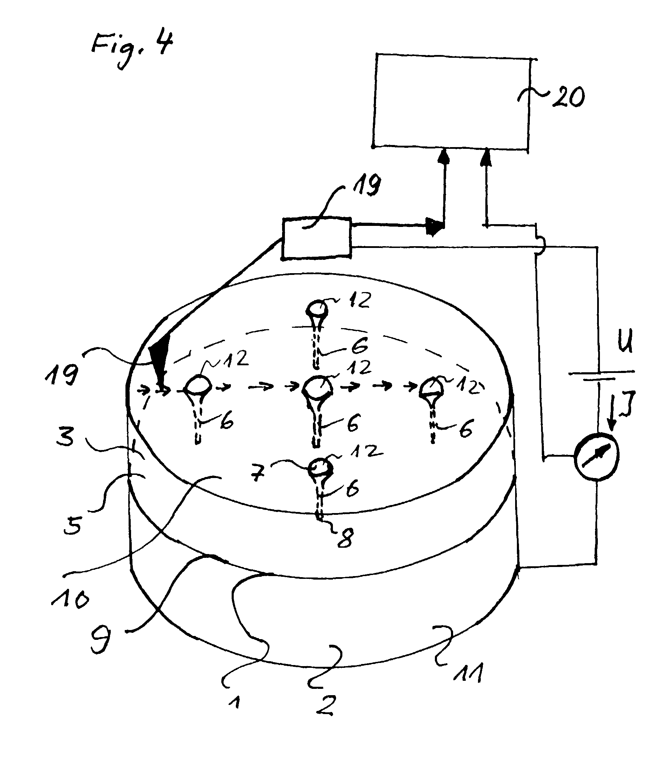

Figure 4 shows a schematic view of a measuring arrangement to measure and prove the quantum wire characteristic. For this measurement the array of one-dimensional quantum wires according to figure 1 is subjected to an atomic force microscope or a scanning tunnelling microscope. A tip probe 19 is raster scanned across the surface 10 as shown by the arrows on surface 10 of the film 5 and hits the bumps 12 protruding from this surface 10. Between the tip 19 and the substrate 11 a voltage U is applied and the current I is measured.

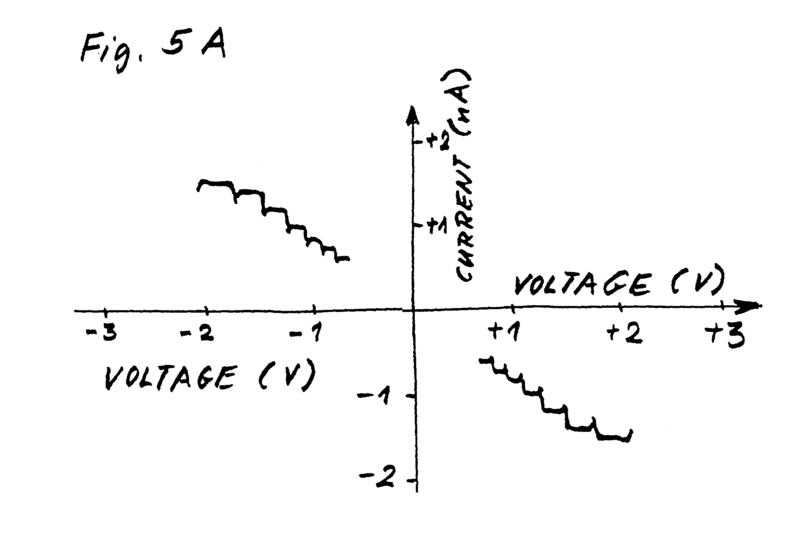

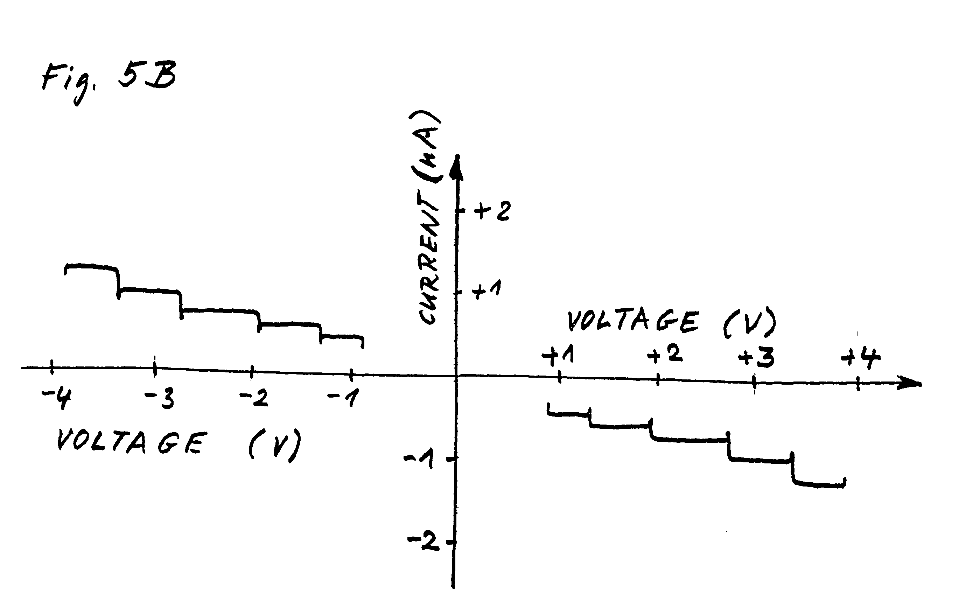

The results of these measurements are shown in figure 5A to figure 5D which illustrate the characteristic I-V curve of different quantum wires. The range of the diagrams of figure 5A to figure 5B is about ± 4 V and ± 8 nA. Figure 5A shows a current which is quantized in the range of 1 nA between + 0.5 nA and + 1.5 nA with a voltage between -2 and -0.8 V and between - 0.5 nA and - 1.5 nA with a voltage between + 2 and + 0.8 V. As one can clearly see, the current is not proportional to the voltage but shows staircase-like characteristic curve, having 7 measured small steps of about Δ 0.1 nA. Figure 5B is measured showing a current between + 0.3 and + 1.5 nA in 5 steps between a voltage of + 0.8 and 3.8 V and between - 0.3 and - 1.5 nA in 5 steps between a voltage of - 0.8 and- 3.8 V. There are only five but large steps measured compared to figure 5B.

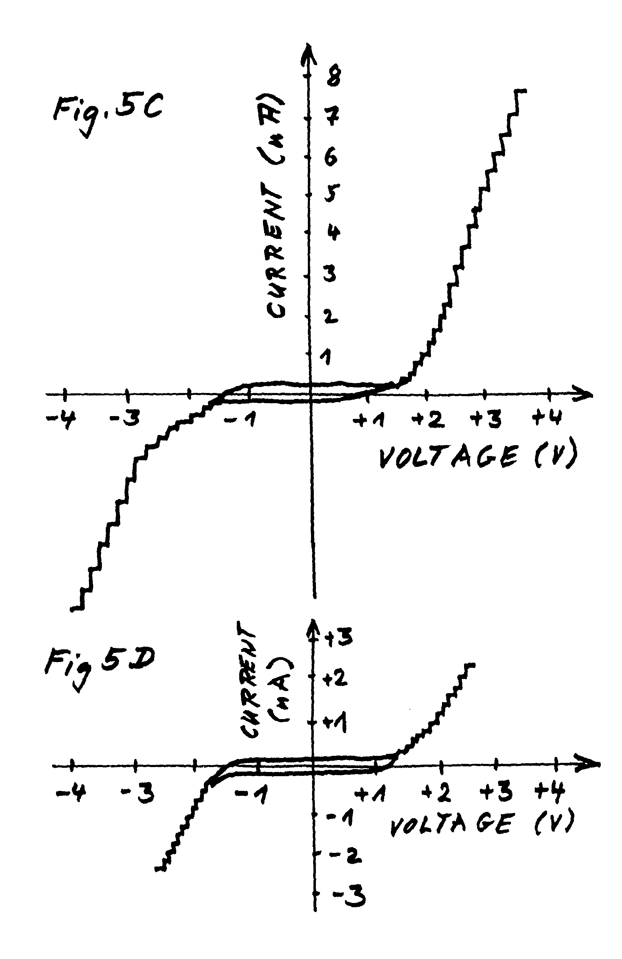

Figure 5C indicates again from -4 V to +4 V an example with large steps in both regions whilst figure 5D shows an example of a different quantum wire with small steps so that it is considered that the question of large or small steps depends more or less on the specific characteristic of each quantum wire besides on the voltage applied to the array of one-dimensional quantum wires. With these measurements shown in figure 5A to 5D it is proven that the conductive wires created by ion impingement on a film surface of insulating or semi-insulating material actually are quantum wires. The intensity of the ion beam can be controlled from one ion per second up to 10⁷ ions per seconds per cm² without destroying the insulating film, that means, it is possible to create arrays with individually positioned quantum wires at predetermined locations as well as a high number quantum wires arbitrarily distributed over a large surface. Further, it is possible to create in one film thickness quantum wires of different longitudinal extensions by varying the angle of impingement of the heavy ion beam.

With the above embodiment it is demonstrated using an atomic force microscope 20 and/or a scanning tunnelling microscope as hybrid scanning probe microscope at room temperature in an ambient air of the case of a diamond-like carbon film that conducting wires are formed with a length according to the thickness of the film with an upper end portion of less than 10 nm diameter with respect to a correction factor depending on the tip shape of the probe determined by the data of an atomic force microscope and/or scanning tunnelling microscope. These wires are so-called "quantum wires" since they exhibit the characteristic staircase-like "current versus voltage" spectroscopy curves (shown in figure 5A to 5C), as expected for quantum mechanical (quantized) transport of electrons in a one-dimensional structure. These spectroscopy data conclusively confirm that the actual continuous electrical wire is much thinner in its diameter than the observed diameter of the upper portion on the surface of said film.

The fabrication is quite easy and cost-effective since such an array could be fabricated and produced directly by ion irradiation without further treatment, that means, large arrays parallel and in subgroups of various angles quantum wires can be created which electronically interconnects on two faces of a solid film or foil, which are firmly embedded in this otherwise electrically completely insulating matrix material. Therefore, these "quantum wires" are easily accessible at their ends and thermally cooled especially if they are embedded in a diamond-like carbon film or in a sheet with very high thermal conductivity. Such arrays of one-dimensional quantum wires can be applied as interconnect structures in quantum mechanical computers. Further, new concepts of digital logic circuitry as shown in figure 2 and 3 can be designed for room temperature by surrounding each quantum wire at the film surface with a nanometer-scale quantum interference device which is normally a ring wire with similar capabilities like a cooled super conducting quantum interference device (SQUID)but operating according to the present invention at room temperature. In such a structure each quantum wire represents one cell wherein the quantized current levels represent the stored information and the read out is done by the quantum interference device measuring the current flowing along the quantum wire by detecting the magnetic field produced by this current. By matching parameters the leads to this quantum interference ring could be other horizontally extending quantum wires fabricated SIMILAR by irradiation and thus a network of such logical units is formed.

With this new technology extreme further miniaturisation in electronics is possible. Further faster switching times in nanometer scale devices with ballistic charge carrier transport without significant energy dissipation could be accomplished without any thermal problems at high switching speed. A convenient production of a large number of such wires in very short time is possible since the typical beam current in an ion accelerator is more than 10¹⁷ ions per cm² per second, wherein each single ion is generating one quantum wire.

Much more than two states of information per logic unit are now possible as current levels can be resolved in the staircase current voltage curve which is already in the above shown figures 5A to 5D up to 7 steps. That means, the logical unit could count, for example, from 0 to 7 or even more and not only between 0 and 1 as in binary transistor logic. Such quantum wires have also a very long lifetime, since they are firmly and tightly embedded in a solid matrix and cannot be oxidised or degraded in ambient environment and are thus very effectively cooled, especially in the case of films with extreme thermal conductivity.

## Claims

1. An array of one-dimensional quantum wires useable for electronic circuitry, logic circuitry and flat display circuitry
**characterised in that**
the array comprises a semi-insulating or insulating solid film (5) and a plurality of one dimensional quantum wires (6) completely firmly and tightly embedded with their longitudinal extension within said film (5) and accessible at their end portions (7, 8) on both surfaces of said film (5).

2. The array of one-dimensional quantum wires according to claim 1,
**characterised in that**
said plurality of quantum wires (6) exhibit a staircase-like current (I) versus voltage (U) characteristic curve at room temperature.

3. The array of one-dimensional quantum wires (6) according to one of the previous claims,
**characterised in that**
said end portions of said plurality of quantum wires (6) are arbitrarily arranged in respect to the surface (9, 10) of said film (5) in an average centre distance between 10 and 5000 nm.

4. The array of one-dimensional quantum wires (6) according to one of the previous claims,
**characterised in that**
said end portions of said plurality of quantum wires (6) are arbitrarily arranged in respect to the surface of said film (5) in an average centre distance between 10 and 40 nm.

5. The array of one-dimensional quantum wires (6) according to one of the previous claims,
**characterised in that**
said longitudinal extension of said plurality of quantum wires (6) within said film (5) is more than 100 nm and less than 2000 nm.

6. The array of one-dimensional quantum wires (6) according to one of the claims 1 to 4,
**characterised in that**
said longitudinal extension of said plurality of quantum wires (6) is less than 100 nm and more than 20 nm.

7. The array of one-dimensional quantum wires (6) according to one of the previous claims,
**characterised in that**
said one dimensional quantum wire has partially a diameter of less than 2 nm within said film (5) and more than 2 nm up to 10 nm near to and on the surface of said film (5).

8. The array of one-dimensional quantum wires (6) according to one of the previous claims,
**characterised in that**
said plurality of quantum wires (6) have straight axis which are arranged parallel to each other.

9. The array of one-dimensional quantum wires (6) according to one of the previous claims,
**characterised in that**
said plurality of quantum wires (6) have straight axis which are perpendicular or oblique in respect to the surface (9, 10) plane of the film (5) with different angles in different areas of one array or with different angles for different arrays.

10. The array of one-dimensional quantum wires (6) according to one of the previous claims,
**characterised in that**
said film (5) comprises amorphous carbon with diamond-like bonds.

11. The array of one-dimensional quantum wires (6) according to one of the claims 1 to 9,
**characterised in that**
said film (5) comprises silicon carbid.

12. The array of one-dimensional quantum wires (6) according to one of the claims 1 to 9,
**characterised in that**
said film (5) comprises polymers containing carbon.

13. The array of one-dimensional quantum wires (6) according to one of the claims 1 to 9,
**characterised in that**
said film (5) comprises amorphous semiconductors.

14. The array of one-dimensional quantum wires (6) according to one of the previous claims,
**characterised in that**
each of said quantum wires (6) represents one logic cell of a multi level logic device, wherein the quantized current levels represent a stored information and a read out is done by a quantum interference device, measuring the current flowing along the quantum wire by detecting the magnetic field produced by said current.

15. Application of the array of one-dimensional quantum wires (6) according to one of the previous claims, as an interface layer between nanometer scale electronic devices interconnecting logical units to form a logical network,
wherein the quantum interference device detectors (30) are realised on the basis of quantum wires.

16. Application of the array of one-dimensional quantum wires (6) according to one of the claims 1 to 9 as an interconnect structure for nanometer-electronic structures of multi level logic computers based on the quantum-mechanical effect of the one-dimensional quantum wire.

17. Application of the array of one-dimensional quantum wires (6) according to one of the claims 1 to 9 as a quantum interference device at room temperature.

18. A method for producing an array of one-dimensional quantum wires (6) according to one of the previous claims,
**characterised by the following steps**
depositing an insulating or semi-insulating film (5) on a conductive substrate (11),
creating latent ion tracks to form quantum wires (6) within said film (5) by directing a beam of fast heavy ions toward the surface of said film (5),
forming submicrometer conductive lines (17) and terminals on said film (5).

19. A method for producing an array of one-dimensional quantum wires (6) according to claim 18,
**characterised in that**
said substrate (11) is formed of a highly doped mono-crystalline silicon wafer.

20. A method for producing an array of one-dimensional quantum wires (6) according to one of claims 1 to 17,
**characterised by the following steps**
forming submicrometer conductive lines and contact terminals on an insulating or semi-insulating substrate,
depositing an insulating or semi-insulating film (5) on said substrate having said conductive lines,
creating latent ion tracks to form quantum wires (6) with said film (5) by directing a beam of fast heavy ions toward the surface of said film (5),
forming submicrometer conductive lines and terminals on said film (5).

21. The method for producing an array of one-dimensional quantum wires (6) according to one of claims 18 to 20,
**characterised in that**
said film (5) is made of amorphous carbon with diamond-like bonds.

22. The method for producing an array of one-dimensional quantum wires (6) according to one of claims 18 to 20,
**characterised in that**
said film (5) is made of silicon carbid.

23. The method for producing an array of one-dimensional quantum wires (6) according to one of claims 18 o 20,
**characterised in that**
said film (5) is made of polymers containing carbon.

24. The method for producing an array of one-dimensional quantum wires (6) according to one of claims 18 to 20,
**characterised in that**
said film (5) is made of amorphous semiconductors.

25. The method for producing an array of one-dimensional quantum wires (6) according to one of claims 18 to 24,
**characterised in that**
the beam current of said fast heavy ions is performed in an ion accelerator emitting between 1 and 10⁷ ions per second.

26. The method for producing an array of one-dimensional quantum wires (6) according to one of claim 18 to 24,
**characterised in that**
the beam current of said fast heavy ions is performed in an ion accelerator emitting between 1 x 10⁵ and 1 x 10⁷ ions per cm² per second.

27. The method for producing an array of one-dimensional quantum wires (6) according to one of claim 18 to 26,
**characterised in that**
said ion beam impinges said film (5) perpendicular or oblique to the film (5) surface.

28. The method for producing an array of one-dimensional quantum wires (6) according to one of claims 18 to 26,
**characterised by the step**
directing said ion beam under different angles in respect to the surface plane of said film (5) in different areas of said array to be produced.

29. The method for producing an array of one-dimensional quantum wires (6) according to one of claims 18 to 26,
**characterised by the step**
directing said ion beam under different angles in respect to the surface plane of said film (5) in identical areas of said array to produce counter oblique quantum wires (6) within the film (5).

30. A method for producing an array of one-dimensional quantum wires (6),
**characterised by the following steps**
depositing an insulating or semi-insulating film (5) on a conductive substrate (11),
forming submicrometer conductive lines (17) and terminals on said film (5),
creating latent ion tracks to form quantum wires (6) within said film (5) by directing a beam of fast heavy ions toward the surface of said film (5).
